# EUROPEAN PATENT APPLICATION

(11) **EP 2 564 968 A1**
(43) Date of publication of application: **06.03.2013**
(21) Application number: 11853889.1
(22) Date of filing: 27.12.2011
(51) Int. Cl.: B23K 20/12, B22F 3/24, C22C 29/04

(54) **ROTATION TOOL**

(30) Priority: 28.12.2010 JP 2010292364
(71) Applicant: Sumitomo Electric Industries, Ltd., Chuo-ku Osaka-shi Osaka 541-0041 (JP)
(72) Inventor: MORIGUCHI, Hideki, Itami-shi Hyogo 664-0016 (JP); UTSUMI, Yoshiharu, Itami-shi Hyogo 664-0016 (JP); MIYAZAKI, Hiroka, Itami-shi Hyogo 664-0016 (JP)
(74) Representative: Grünecker, Kinkeldey, Stockmair & Schwanhäusser
(86) International application number: PCT/JP2011/080209
(87) International publication number: WO 2012/091011

(57) **Abstract**

A friction stir welding tool (1) is provided which allows for excellent wear resistance and high joining strength even in a process of joining difficult-joining materials. A friction stir welding tool (1) of the present invention is used for a friction stir welding process and includes a base material (4). The base material (4) includes a hard phase and a binder phase. The hard phase includes TiCN. The binder phase is made of an iron group metal. A mass ratio Bₛ of the binder phase to the base material (4) in a region having a thickness of 20 µm from a surface of the base material (4) is smaller than a mass ratio Bᵢ of the binder phase to the base material (4) in a region beyond the thickness of 20 µm from the surface of the base material (4).

## Description

### TECHNICAL FIELD

The present invention relates to a friction stir welding tool.

### BACKGROUND ART

In 1991, a friction stir welding technique of joining metal materials such as aluminum alloys was established in the United Kingdom. This technique is for joining metal materials by pressing a cylindrical friction stir welding tool having a small-diameter protrusion at a tip thereof against joint surfaces of the metal materials to be joined and rotating the friction stir welding tool to generate frictional heat and soften and plastically flow the metal materials at a joint portion by the frictional heat.

"Joint portion" herein refers to a joint interface portion where joining of metal materials by butting the metal materials or placing one metal material on top of the other metal material is desired. Near this joint interface, the metal materials are softened, plastic flow occurs, and the metal materials are stirred. As a result, the joint interface disappears and joining is performed. Furthermore, dynamic recrystallization occurs at the metal materials at the same time. Due to this dynamic recrystallization, the metal materials near the joint interface become fine particles and the metal materials can be joined to each other with high strength.

When aluminum alloys are used as the above-mentioned metal materials, plastic flow occurs at a relatively low temperature of approximately 500°C. Therefore, even when the friction stir welding tool made of inexpensive tool steel is used, little wear and tear occurs and frequent replacement of the tool is unnecessary. Therefore, in the friction stir welding technique, the cost required to join the aluminum alloys is low. Thus, in place of a resistance welding method for melting and joining aluminum alloys, the friction stir welding technique has already been in practical use in various applications as a technique of joining components of a railroad vehicle, a car, or an aircraft.

At present, the friction stir welding technique is mainly applied to nonferrous metals such as an aluminum alloy or a magnesium alloy in which plastic flow occurs at a relatively low temperature. This friction stir welding technique is superior to the resistance welding method in terms of cost and time required for joining, strength of the joint portion, and the like. Therefore, there is a need for applying the friction stir welding technique to not only joining of the materials in which plastic flow occurs at a low temperature, but also joining of copper alloys or steel materials in which plastic flow occurs at a high temperature of 1000°C or higher.

However, when the friction stir welding technique is applied to the steel materials, the friction stir welding tool itself is exposed to a high temperature during joining. As a result, the friction stir welding tool is plastically deformed, and a portion of the friction stir welding tool in contact with the materials to be joined is readily oxidized and becomes worn, which leads to remarkably short tool life.

As an attempt to solve the above-mentioned problem, Japanese Patent Laying-Open No. 2003-326372 (PTL 1), for example, discloses a technique of achieving long life of a friction stir welding tool by providing a diamond film to coat a portion of a surface of the friction stir welding tool in contact with materials to be joined, so as to increase the surface hardness and suppress a low-melting-point light alloy component of the materials to be joined, such as Al alloys or Mg alloys, from melting and attaching to the friction stir welding tool. In the friction stir welding tool disclosed in PTL 1, wear resistance of the surface thereof can be indeed improved in the joining of the low-melting point light alloys such as the Al alloys or the Mg alloys, thereby achieving long life of the friction stir welding tool.

Although such a diamond film exhibits outstanding wear resistance in joining at a low temperature, the diamond film is readily oxidized during friction stir welding of materials having a melting point exceeding 1000°C, such as steel materials. Accordingly, sufficient wear resistance cannot be exhibited, disadvantageously.

To address this, as a friction stir welding tool capable of joining at a high temperature, Japanese National Patent Publication No. 2003-532542 (PTL 2) proposes to apply a superhigh pressure sintered compact such as a cubic boron nitride (hereinafter, also referred to as "cBN") sintered compact to the friction stir welding tool, instead of the tool steel. However, the cBN sintered compact is an expensive material in the first place. Hence, in view of the cost, it is considered that a friction stir welding tool employing such a cBN sintered compact is less likely to be put into practical use.

As another attempt to suppress deterioration of the surface of the friction stir welding tool, Japanese Patent Laying-Open No. 2005-152909 (PTL 3) discloses a friction stir welding tool including an underlying layer provided on a base material, and an anti-adhesion coating film made of TiN, TiAlN or the like and provided on the underlying layer. According to this friction stir welding tool, adhesion of a metal component (aluminum) in materials to be joined can be prevented even when it is used for a long time, and thus, stable processing can be continued.

### CITATION LIST

### PATENT LITERATURE

PTL 1: Japanese Patent Laying-Open No. 2003-326372
PTL 2: Japanese National Patent Publication No. 2003-532542
PTL 3: Japanese Patent Laying-Open No. 2005-152909

### SUMMARY OF INVENTION

### TECHNICAL PROBLEM

However, when the friction stir welding tool disclosed in PTL 3 is used for joining of difficult-joining materials having a melting point of 1000°C or greater such as steel, the surface of the friction stir welding tool is exposed to a high temperature of 1000°C or greater, with the result that wear proceeds remarkably faster than that in the case of friction-stir welding of joining materials such as Al alloys or Mg alloys to each other. This leads to short tool life.

The present invention has been made in view of the circumstance described above, and has its object to provide a friction stir welding tool allowing for excellent wear resistance and high joining strength even in the case of a process of joining difficult-joining materials to each other.

### SOLUTION TO PROBLEM

A friction stir welding tool of the present invention is used for a friction stir welding process and includes a base material, the base material including a hard phase and a binder phase, the hard phase including TiCN and further including a compound or a solid solution of the compound, the compound being composed of one or more metals selected from a group consisting of Ti, Zr, Hf, V, Nb, Ta, Cr, Mo, and W and one or more elements selected from a group consisting of nitrogen, carbon, boron, and oxygen, the binder phase being made of an iron group metal, a mass ratio Bₛ of the binder phase to the base material in a region having a thickness of 20 µm from a surface of the base material being smaller than a mass ratio Bᵢ of the binder phase to the base material in a region beyond the thickness of 20 from the surface of the base material.

Preferably, a mass ratio Bₛ/Bᵢ, which is a mass ratio of Bₛ to Bᵢ, is 0 to 0.9. Preferably, a mass ratio of the Ti compound to the base material in the region having the thickness of 20 µm from the surface of the base material is higher than a mass ratio of the Ti compound to the base material in the region beyond the thickness of 20 µm from the surface of the base material. Preferably, a portion of the base material in contact with materials to be joined has a surface roughness Ra of 0.3 µm or smaller.

Preferably, the friction stir welding tool includes the base material and a coating layer formed on the base material. Preferably, the coating layer has an oxidation resistance of 1000°C or greater.

Preferably, the friction stir welding process using the friction stir welding tool is spot friction stir welding.

The present invention provides a method for joining materials using the friction stir welding tool described above, the materials to be joined having a melting point of 1000°C or greater.

### ADVANTAGEOUS EFFECTS OF INVENTION

Because the friction stir welding tool of the present invention is configured as above, the friction stir welding tool exhibits an effect of providing excellent wear resistance and high joining strength in a process of joining difficult-joining materials to each other.

### BRIEF DESCRIPTION OF DRAWINGS

Fig. 1 is a schematic cross sectional view showing an exemplary friction stir welding tool of the present invention.
Fig. 2 is a schematic cross sectional view showing another exemplary friction stir welding tool of the present invention.

### DESCRIPTION OF EMBODIMENTS

The following describes the present invention more in detail.

### <Friction Stir Welding Tool>

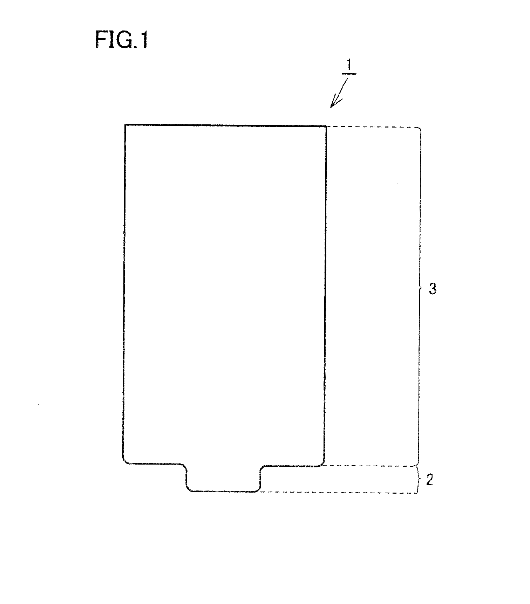

Fig. 1 is a schematic cross sectional view showing a friction stir welding tool of the present invention. As shown in Fig. 1, a friction stir welding tool 1 of the present invention is shaped to include a probe portion 2 having a small diameter (for example, a diameter of not less than 2 mm and not more than 8 mm), and a cylindrical portion 3 having a large diameter (for example, a diameter of not less than 4 mm and not more than 20 mm). Friction stir welding tool 1 is extremely advantageously usable for applications of Friction Stir Welding (FSW) and spot FSW, for example.

In the case where the friction stir welding tool of the present invention is used for joining, probe portion 2 is rotated with probe portion 2 being inserted into or pressed against a joint portion of materials to be joined. In this way, the materials are joined to each other. In this case, in the friction stir welding application, probe portion 2 is pressed against or inserted into two materials to be joined that are stacked or butted in a line contact manner, and rotating probe portion 2 is moved linearly with respect to the stacked or butted portion, and thereby the materials to be joined are joined. On the other hand, in the spot friction stir welding application, rotating probe portion 2 is pressed against a desired joint spot of two materials to be joined that are vertically stacked or butted, and rotation of probe portion 2 is continued at this location, and thereby the materials to be joined are joined.

The present invention also relates to a method for joining materials using the friction stir welding tool, wherein the materials to be joined has a melting point of 1000°C or greater. The friction stir welding tool according to the present invention is also capable of joining the materials having a melting point of 1000°C or greater, which has been considered to be difficult conventionally using a friction stir welding tool. Therefore, the friction stir welding tool according to the present invention has very excellent industrial applicability.

As mentioned above, friction stir welding tool 1 according to the present invention can be used in various applications, and particularly, can be suitably used for joining of high-tensile steel, for which the resistance welding method has been mainly used conventionally. In other words, in the above-mentioned joining of high-tensile steel, friction stir welding tool according to the present invention provides an alternative to the conventional resistance welding method. In friction stir welding, the materials to be joined are joined in a solid-phase state and dynamic recrystallization occurs at the joint portion, and thus, the structure becomes fine. As a result, the strength of the joint portion is increased as compared with the conventional resistance welding method in which the materials to be joined change into a liquid phase during joining. Therefore, the friction stir welding tool according to the present invention can be very effectively used for joining of high-tensile steel having high specific strength, and in particular, joining of ultrahigh tensile steel of 980 MPa or greater. Further, the friction stir welding tool is less likely to have a defect even in the case of spot friction stir welding of such ultrahigh-tensile steel. The above-mentioned friction stir welding tool according to the present invention can be suitably used to join the materials that are made of a high-melting-point material. Further, this tool can be also used in a friction stir process.

### <Base Material>

Friction stir welding tool 1 of the present invention includes a base material. The base material includes a hard phase and a binder phase. A mass ratio Bₛ of the binder phase to the base material in a region (hereinafter, also referred to as "base material surface portion") having a thickness of 20 µm from a surface of the base material is smaller than a mass ratio Bᵢ of the binder phase to the base material in a region (hereinafter, also referred to as "base material internal portion") beyond the thickness of 20 µm from the surface of the base material. Because mass ratio Bₛ of the binder phase to the base material in the base material surface portion is smaller than the mass ratio of the binder phase to the base material in the base material internal portion, the hard phase constituting the base material surface portion is relatively increased to result in increased hardness of the base material surface and improved wear resistance and plastic deformation resistance of the friction stir welding tool.

Further, even when the surface of the friction stir welding tool has a high temperature due to frictional heat resulting from rotation of the friction stir welding tool, the surface is less likely to be oxidized, with the result that oxidation resistance and joining quality can be improved. Moreover, because the binder phase in the base material surface portion is relatively decreased, the thermal conductivity of the base material surface portion is decreased to fall below the thermal conductivity of the base material internal portion. Accordingly, the base material surface portion serves as a heat insulating layer, whereby the frictional heat generated during the joining is less likely to be transmitted to the base material internal portion. This exhibits an effect specific to the friction stir welding tool, i.e., the frictional heat generated during the joining is effectively consumed for plastic flow of the materials to be jointed. This leads to energy saving. Further, by adjusting the mass ratio of the binder phase to the base material in the base material surface portion as described above, compressive residual stress of approximately 0.2 GPa to 2 GPa can be generated in the base material surface portion, thereby improving defect resistance.

A mass ratio Bₛ/Bᵢ, which is a mass ratio of Bₛ to Bᵢ, is preferably 0 to 0.9. Accordingly, the wear resistance and oxidation resistance of the friction stir welding tool can be improved. Bₛ/Bᵢ is more preferably 0 to 0.7, further preferably 0 to 0.5. On the other hand, when Bₛ/Bᵢ exceeds 0.9, the effect provided by the reduction of the mass ratio of the binder phase in the base material surface portion will be decreased to result in insufficient wear resistance and oxidation resistance. It should be noted that the value employed for mass ratio Bₛ/Bᵢ of the binder phase is calculated based on values obtained by an electron probe micro analyzer (EPMA) performing quantitative analysis on the cross sectional surface of the friction stir welding tool so as to obtain the mass ratio of the binder phase to the base material in the region having the thickness of 20 µm from the surface of the base material as well as the mass ratio of the binder phase to the base material in the region beyond the thickness of 20 µm from the surface of the base material.

A mass ratio of a Ti compound to the base material in the base material surface portion is preferably higher than the mass ratio of the Ti compound to the base material in the base material internal portion. The Ti compound is excellent in oxidation resistance. Hence, by increasing the mass ratio of the Ti compound to the base material in the base material surface portion, the wear resistance and oxidation resistance of the friction stir welding tool can be improved. It should be noted that fluctuations of the mass ratio of the Ti compound in the base material are evaluated by analyzing the cross sectional surface of the base material using the electron probe micro analyzer (EPMA). It should be noted that in the base material of the present invention, surface roughness Ra of the base material surface portion possibly becomes too rough in the course of increasing/decreasing the ratio of the binder phase in each of the base material surface portion and the base material internal portion. Hence, it is preferable to smooth the surface roughness of the base material surface portion making contact with the materials to be joined, by means of a polishing process, a blasting process, or the like. Specifically, the portion of the base material in contact with the materials to be joined preferably has a surface roughness Ra of 0.3 µm or smaller. With such a surface roughness, frictional heat is less likely to be generated at the surface of the base material at an initial stage of the joining, thereby achieving long life of the friction stir welding tool. Meanwhile, when the portion of the base material in contact with the materials to be joined has a surface roughness Ra exceeding 0.3 µm, excess frictional heat is generated at the initial stage of the joining to unfavorably result in decreased life of the friction stir welding tool.

When cemented carbide is used as the base material, the effects of the present invention are exhibited even if the cemented carbide includes free carbon or an abnormal phase called η phase in the structure thereof.

### <Hard Phase>

In the present invention, the hard phase is contained in the base material to increase hardness and plastic deformation resistance of the base material. Such a hard phase includes TiCN, and further includes a compound or a solid solution of the compound. The compound is composed of one or more metals selected from a group consisting of Ti, Zr, Hf, V, Nb, Ta, Cr, Mo, and W, and one or more elements selected from a group consisting of nitrogen, carbon, boron, and oxygen. Examples thereof include TiC, ZrCN, HfC, VC, NbC, TaC, Cr₃C₂, Mo₂C, WC, (Ti, Mo) (C, N), (Ti, W, Mo) (C, N). (Ti, W, Ta, Nb, Mo) (C, N), and the like. Such a hard phase is preferably contained at not less than 75 mass % and not more than 98 mass % relative to the base material. When the hard phase is less than 75 mass %, the hardness becomes low to result in insufficiency of various properties such as the plastic deformation resistance. When the hard phase is more than mass %, the strength possibly becomes insufficient, unfavorably.

### <Binder Phase>

In the present invention, the binder phase is contained in the base material to connect the hard phases to each other. Such a binder phase may be any binder phase as long as it is made of an iron group metal. As the iron group metal used for the binder phase, Co or Ni can be used. Each composition ratio thereof can be appropriately changed. Further, the material used for the binder phase is not limited to only Co and Ni. Fe can be used, and the element(s) constituting the hard phase or Cr may be contained. Such a binder phase is preferably contained at not less than 3 mass % and not more than 28 mass % relative to the base material. When the binder phase is less than 3 mass %, the strength possibly unfavorably becomes insufficient. On the other hand, when the binder phase is more than 28 mass %, a volume ratio of the hard phase is relatively decreased to possibly result in insufficiency of various properties such as the hardness and the plastic deformation resistance.

### <Method for Manufacturing Base Material>

The base material used for the friction stir welding tool of the present invention is preferably fabricated as follows. First, raw material powders to constitute the hard phase and raw materials powder to constitute the binder phase are mixed, are then provided with ethanol, and are stirred for approximately 4 hours to 10 hours using an attritor. With the ethanol being then volatilized, uniaxial pressing is performed at a pressure of 100 MPa, and then sintering is performed at 1200°C to 1700°C for approximately 1 hour to 3 hours to obtain a sintered compact. This sintered compact is ground using a diamond grindstone or the like and then is subjected to a blasting process to obtain surface smoothness, thereby fabricating the friction stir welding tool.

In order to increase the mass ratio of the Ti compound in the base material surface portion within the base material fabricated as above, it is effective to appropriately control a heating rate, atmospheric gas, pressure, and the like during the sintering, or a cooling rate, atmospheric gas, pressure, and the like after the sintering. In particular, it is effective to increase nitrogen partial pressure by introducing nitrogen during the sintering. It is preferable to set the nitrogen partial pressure at 10 Torr to 500 Torr. Further, in order to decrease the mass ratio of the binder phase in the base material surface portion, for example, it is effective to control the cooling rate in the cooling process after the sintering, in vacuum atmosphere or nitrogen or inert gas atmosphere under reduced pressure. It is preferable to perform the cooling at a cooling rate of approximately 3°C/minute to 30°C/minute.

### <Coating Layer>

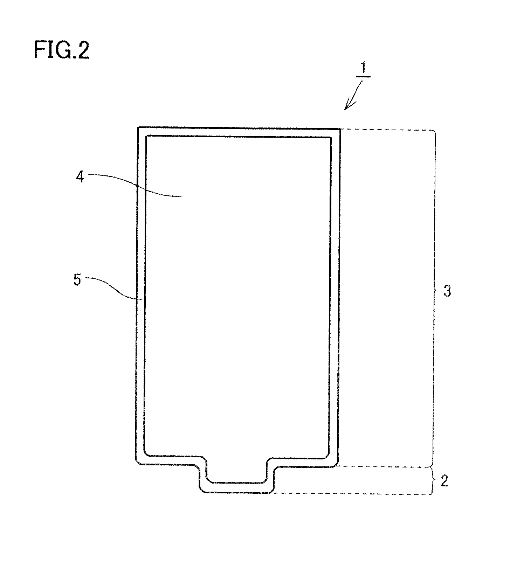

Fig. 2 is a schematic cross sectional view showing another embodiment of the friction stir welding tool according to the present invention. The friction stir welding tool of the present invention preferably includes a coating layer 5 formed on base material 4 as shown in Fig. 2. Such a coating layer 5 may be constituted of one layer having a single composition, or may be constituted of a stack including two or more layers having different compositions. The coating layer thus included can provide a function of improving various properties such as the wear resistance, the oxidation resistance, and the toughness. In particular, in the base material surface portion, the base material of the present invention contains a relatively small amount of the binder phase having a high thermal expansion coefficient, whereby the thermal expansion coefficient of the base material surface portion becomes lower than that of the base material internal portion and becomes close to that of the coating layer. Accordingly, in the application of friction stir welding in which heating is performed up to a temperature of 1000°C or greater before performing the cooling, the coating layer can be suppressed from being peeled or chipped, thereby greatly contributing to long life of the friction stir welding tool.

Such a coating layer is provided to give the above-mentioned properties. In addition to the properties, the coating layer can give an effect of enhancing various properties such as a coloring property for identifying a consumed probe of friction stir welding tool 1. Further, coating layer 5 is preferably formed to coat the entire surface of base material 4 as shown in Fig. 2, but the coating layer may not coat a part of the base material, or the coating layer may have a different configuration at any portion on the base material. It should be noted that the coating layer in the present invention may coat only the shoulder portion in which oxidation is likely to take place noticeably during the joining process.

Further, the coating layer described above preferably has an oxidation resistance of 1000°C or greater. Here, the expression "have an oxidation resistance of 1000°C or greater" is intended to indicate that a temperature at which the weight of the coating layer is increased is 1000°C or greater when evaluating the coating layer in an atmosphere using a thermogravimetry/differential thermal analysis (TG/DTA) device.

Here, the coating layer is preferably made of a material having a thermal expansion coefficient of not less than 7 × 10⁻⁶ and not more than 9 × 10⁻⁶. The coating layer is more preferably made of nitride of one or more metals selected from a group consisting of Ti, Al, Cr, Si, Hf, Zr, Mo, Nb, Ta, V, and W. Such a nitride layer may contain oxygen or may contain carbon. With oxygen being contained, the oxidation resistance can be improved. With carbon being contained, the wear resistance can be improved.

Particularly, examples of the composition of the nitride layer having an oxidation resistance of 1000°C or greater include TiMoSiN, TiSiN, AlWN, AIWSiN, AlTaN, AlTaSiN, AlHfN, AlHfSiN, AlMoN, AlMoSiN, AINbSiN, AlZrN, AlZrSiN, AlSiN, VSiN, CrVN, CrMoN, CrSiN, CrZrN, CrAlN, CrWSiN, CrTiSiN, AlTiSiN, AlTiCrN, CrAlN, CrAlSiN, TiHfSiN, TiWSiN, TiAlSiN, and the like.

The coating layer in the present invention preferably has a thickness of not less than 1 µm and not more than 50 µm. Since the coating layer has a thickness of 1 µm or greater as mentioned above, the wear resistance can be improved and the tool life can be significantly lengthened. More preferably, the coating layer in the present invention has a thickness of not less than 5 µm and not more than 40 µm, and further preferably not less than 10 µm and not more than 20 µm. As a result, the tool life can be further lengthened and excellent defect resistance can also be achieved.

In the present invention, it is assumed that a value calculated using a transmission electron microscope (TEM) is employed for the thickness of the coating layer. The thickness of the coating layer refers to the thickness of the coating layer on any portion of the surface of the friction stir welding tool. For example, the thickness of the coating layer refers to the thickness of the coating layer, which is formed on the base material of the friction stir welding tool, on the tip of the probe portion.

### <Method for Forming Coating Layer>

Coating layer 5 of the present invention is required to coat base material 4 with high adhesion therewith. Hence, coating layer 5 is preferably formed by means of a film forming process allowing for high adhesion with base material 4. Any conventionally known film forming process can be used as the above-mentioned film forming process. For example, a PVD (physical vapor deposition) method, a CVD (chemical vapor deposition) method, and the like can be used, and two or more conventionally known film forming processes may be combined.

Among these film forming processes, the use of the PVD method is particularly preferable because the coating layer is not readily cracked after coating layer 5 is formed, and the oxidation resistance can be improved. When the coating layer is cracked and the friction stir welding tool is exposed to a high temperature of 1000°C or greater during the joining process, oxygen reaches the base material via the crack, with the result that the base material is oxidized to accelerate damage of the tool. Hence, it is very important to form no crack in the coating layer. In this point, the PVD method is much more advantageous than the CVD method. Further, the PVD method allows coating layer 5 to be formed at a low temperature while providing coating layer 5 with distortion. Hence, crystal grains are likely to be formed into fine particles. Thus, even when the coating layer is worn, the size of the worn powder is small, advantageously.

The conventionally known PVD method can be used without particular limitation as the PVD method suitably used in the present invention. Examples of such a PVD method can include a sputtering method, an arc ion plating method, a vapor deposition method, and the like. Particularly, the arc ion plating method or a magnetron sputtering method is preferably employed.

### Examples

While the present invention will be described in more detail hereinafter with reference to examples, the present invention is not limited thereto.

### <Examples 1 to 8 and Comparative Examples 1 to 3>

In each of Examples 1 to 8 and Comparative Examples 1 to 3, the friction stir welding tool shown in Fig. 1 was fabricated. The friction stir welding tool in the present example had cylindrical portion 3 having a substantially cylindrical shape whose diameter was 10 mm and whose height was 20 mm, and probe portion 2 protruding concentrically with cylindrical portion 3 at a central portion of the tip of cylindrical portion 3. Probe portion 2 had a substantially cylindrical shape whose diameter was 4 mm and whose height was 2 mm.

First, mixed powders were obtained by mixing raw material powders to constitute the hard phase with raw material powders to constitute the binder phase, at a mass ratio shown in Table 1 below. Employed here as the raw material powders to constitute the hard phase were: TiCN (TiC/TiN = 1 in a mass ratio) having a mean particle size of 1.5 µm; TiC powders having a mean particle size of 1.5 µm; WC powders having a mean particle size of 0.8 µm, NbC powders having a mean particle size of 1 µm; TaC powders having a mean particle size of 1 µm; and Mo₂C powders having a mean particle size of 1 µm. Employed as the raw material powders to constitute the binder phase were: Ni powders having a mean particle size of is 5 µm; and Co powders having a mean particle size of 1.5 µm.

By adding ethanol to the mixed powders and then stirring them for 7 hours using an attritor, an slurry was obtained which had the material of the hard phase and the material of the binder phase mixed with each other. Then, the ethanol contained in this slurry was volatilized, thereby obtaining a sintered compact raw material.

For example, in Example 1, the sintered compact raw material was introduced to fill a mold made of cemented carbide and was uniaxially pressed at a pressure of 100 MPa, thereby obtaining a pressed molded body. This pressed molded body was sintered in vacuum at a temperature of 1500°C for 1 hour, thereby obtaining a sintered compact. The outer circumference of the sintered compact was ground by a diamond grindstone. Meanwhile, the probe portion and the shoulder portion to be brought into contact with the materials to be joined were not ground but were subjected to a blasting process using alumina powders until smoothness thereof was attained up to a surface roughness Ra of 0.25 µm, thus fabricating the friction stir welding tool. It should be noted that the base material of the friction stir welding tool in Example 8 had increased mass ratio Bₛ/Bᵢ and increased of the Ti compound as with the base material of the friction stir welding tool in Example 3, but the probe portion and the shoulder portion thereof was smoothed lightly to attain a surface roughness Ra of 0.5 µm.

It should be noted that in each of the examples and the comparative examples, the sintering was performed at a heating rate of 1°C/minute to 5°C/minute in an atmosphere having a nitrogen partial pressure of 1 Torr to 500 Torr. After the sintering, in vacuum or inert gas atmosphere, cooling was performed at a cooling rate of 1°C/minute to 30°C/minute. Accordingly, the friction stir welding tools were fabricated such that the mass ratio (Bₛ/Bᵢ) of the binder phase to the base material in the base material surface portion and the mass ratio of the Ti compound to the base material therein differ among them.

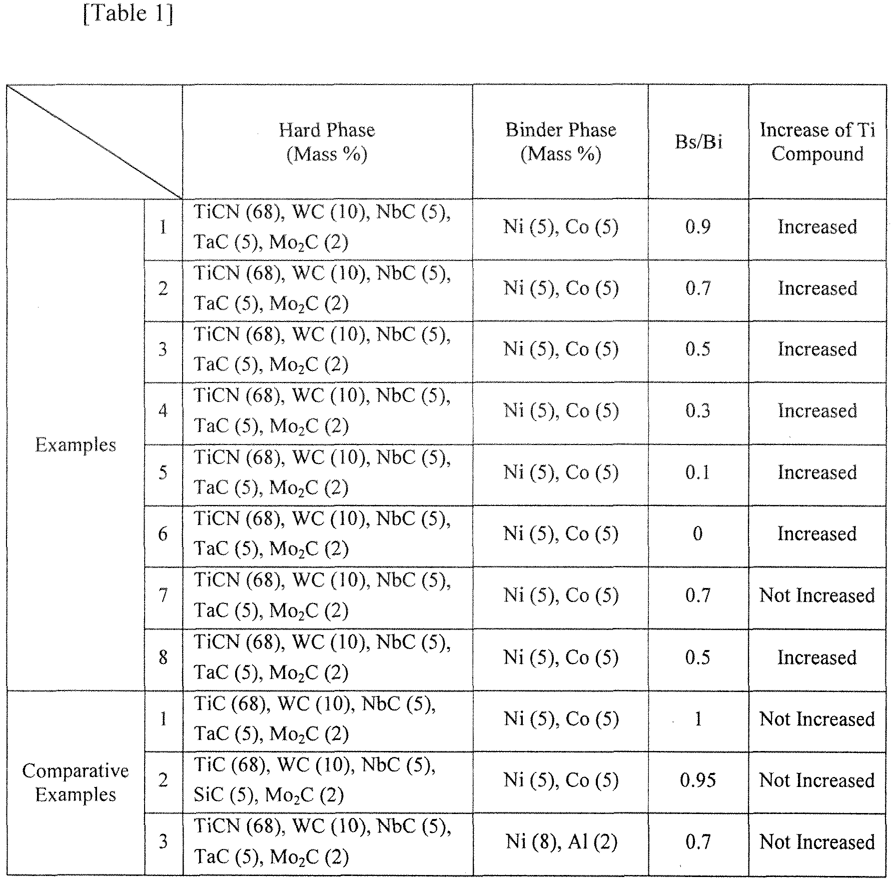

Each of the friction stir welding tools thus fabricated in Examples 1 to 8 included the base material, wherein the base material includes the hard phase and the binder phase and ratio Bₛ/Bᵢ, which is a ratio of mass ratio Bₛ to mass ratio Bᵢ, was 0 to 0.9. Mass ratio Bₛ is the mass ratio of the binder phase to the base material in the region having the thickness of 20 µm from the surface of the base material. Mass ratio Bᵢ is the mass ratio of the binder phase to the base material in the region beyond the thickness of 20 µm from the surface of the base material. In particular, in each of the friction stir welding tools of Examples 1 to 6, the mass ratio of the Ti compound to the base material in the region having the thickness of 20 µm from the surface of the base material is higher than the mass ratio of the Ti compound to the base material in the region beyond the thickness of 20 µm from the surface of the base material.

On the other hand, in the friction stir welding tool of Example 7, the mass ratio of the Ti compound to the base material in the region having the thickness of 20 µm from the surface of the base material is lower than the mass ratio of the Ti compound to the base material in the region beyond the thickness of 20 µm from the surface of the base material.

Each of the friction stir welding tools obtained as above in the examples and the comparative examples was mirror-polished and a crystalline structure in any region of the friction stir welding tool was captured in a photograph using a scanning electron microscope (SEM) at a magnification of 10000. Then, an EPMA attached thereto was used to perform mapping of carbide, carbonitride, and nitride of the hard phase as well as the components of the binder phase in the cross sectional surface of the friction stir welding tool (the surface perpendicular to the tip direction of the probe portion). Then, image processing software was used for the photograph thus captured at a magnification of 10000 while checking the components therein, so as to identify the carbide, carbonitride, and nitride of the hard phase as well as the binder phase. Then, respective total areas of the carbide, carbonitride, and nitride of the hard phase and the binder phase in the photograph were calculated. Then, in the photograph, respective ratios of the hard phase and the binder phase in the friction stir welding tool were calculated in percentage. Then, the mass ratio was calculated based on each of the masses for the components. As a result, the mixing ratio of each of the above-described raw materials, and the mass ratio of each of the compositions constituting the friction stir welding tool finally obtained could be regarded as substantially the same.

Further, the cross sectional surface of the obtained friction stir welding tool of each of the examples and the comparative examples was polished, and the surface thus polished was subjected to quantitative analysis by means of the EPMA to measure mass ratio Bₛ of the binder phase to the base material in the region having the thickness of 20 µm from the surface of the base material, and mass ratio Bᵢ of the binder phase to the base material in the region beyond the thickness of 20 µm from the surface of the base material. Based on the values of Bₛ and Bᵢ, Bₛ/Bᵢ was calculated. Results thereof were shown in Table 1 at a column "Bₛ/Bᵢ".

Further, the Ti compound in the base material surface portion and the Ti compound in the base material internal portion were evaluated using the EPMA to evaluate whether or not the base material surface portion contained a larger amount of the Ti compound than the base material internal portion. When the base material surface portion contained a larger amount of the Ti compound than that of the base material internal portion, a denotation "Increased" is provided in the column "Increase of Ti Compound". On the other hand, when the base material surface portion contained a smaller amount or an equal amount of the Ti compound than or to that of the base material internal portion, a denotation "Not Increased" is provided in the column "Increase of Ti Compound".

### <Example 9>

The base material of the friction stir welding tool of Example 2 was coated with a coating layer having a thickness of 10 µm by means of the cathode arc ion plating method. The coating layer was made of Al_{0.6}Ti_{0.35}Si_{0.05}N. In this way, a friction stir welding tool of Example 9 was fabricated to have the shape shown in Fig. 2. The coating layer made of Al_{0.6}Ti_{0.35}Si_{0.05}N had an oxidation starting temperature of 1130°C. The oxidation starting temperature was found by using a TG/DTA device (Trademark: TG-DTA2020SA (provided by Bruker)) to measure a temperature at which the weight of the coating layer was increased.

### <Example 10>

A friction stir welding tool of Example 10 was fabricated by means of a method similar to that in Example 9 except that the coating layer of Example 9 was changed to have a composition of Ti_{0.5}Al_{0.5}N. The coating layer thus made of Ti_{0.5}Al_{0.5}N had an oxidation starting temperature of 970°C.

Although the coating layer was formed by means of the cathode arc ion plating method in each of Examples 9 and 10, the coating layer can also be formed by means of, for example, a balanced or unbalanced sputtering method. It should be noted that in each of the examples, the thickness of the coating layer was measured by directly observing the cross sectional surface thereof using an SEM or a TEM.

### <Evaluation of Friction Stir Welding Tools>

Each of the friction stir welding tools fabricated in the examples and the comparative examples as above performed spot friction stir welding (FSW) at 3000 spots under conditions shown in Table 2 below. It should be noted that Comparative Example 3 had a defect before joining at 1000 spots and therefore the welding was stopped before welding at 5000 spots.

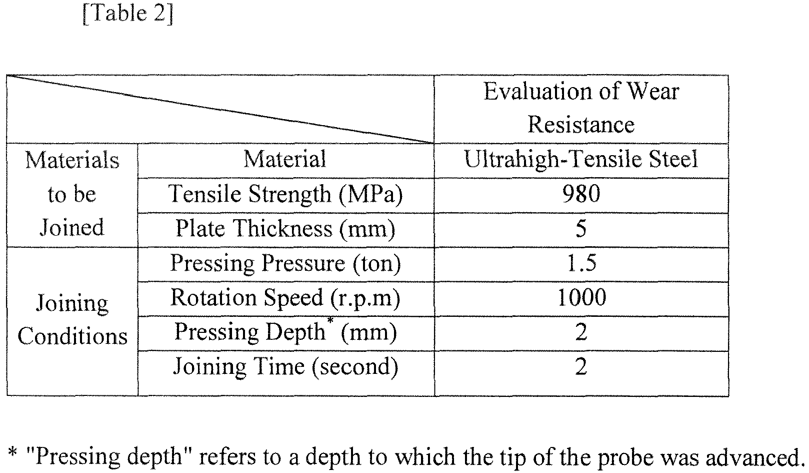

After the spot friction stir welding at 5000 spots as described above, each of the friction stir welding tools was soaked in hydrochloric acid, and wastes adhered to the surface thereof were removed while heating it for 10 minutes. Then, a vernier caliper was used to measure the outer diameters of the shoulder portion and the probe portion of the friction stir welding tool. A difference between each of the outer diameters of the shoulder portion and the probe portion before the spot friction stir welding and each of the outer diameters thereof after the spot friction stir welding was evaluated as an amount of wear, and was provided in a column "Amount of Wear (mm)" in Table 3. It is indicated that as the amount of wear is smaller, the wear resistance is more excellent.

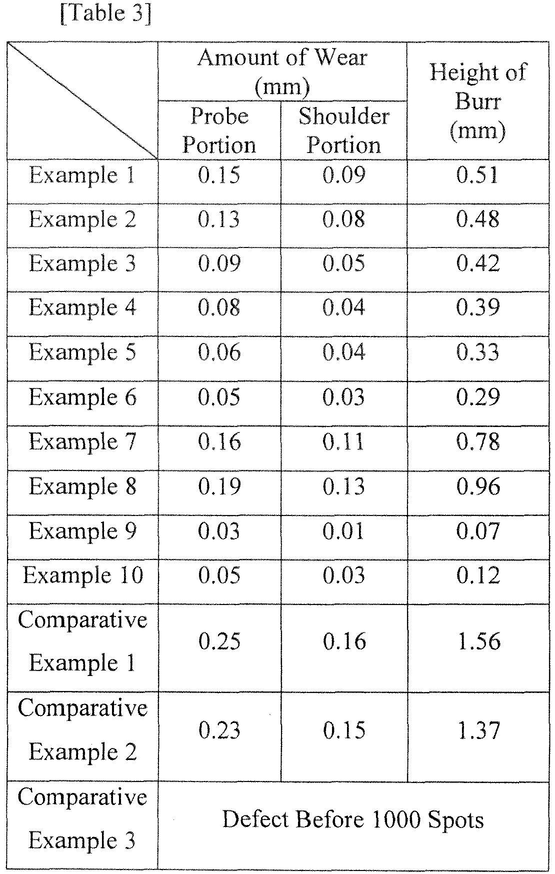

The column "Height of Burr" in Table 3 shows the height of a burr projecting the most from the surface of the joined material after the welding. It is indicated that as the height of the burr is smaller, the joining quality is more excellent.

### <Results of Evaluation on Friction Stir Welding Tools>

As apparent from Table 3, the probe portion and the shoulder portion of each of the friction stir welding tools of Examples 1 to 7 in the present invention had smaller amounts of wear than those in Comparative Examples 1 to 3. Thus, apparently, the wear resistance and the oxidation resistance of the friction stir welding tool were improved. Further, in each of the friction stir welding tools of Examples 1 to 7, the height of burr was smaller than those in Comparative Examples 1 to 3. Thus, apparently, the joining quality provided by the friction stir welding tool was improved.

Meanwhile, in the friction stir welding tool of Comparative Example 1, the mass ratio of the binder phase to the base material in the base material surface portion was equivalent to the mass ratio of the binder phase to the base material in the base material internal portion, thus failing to improve the wear resistance and the oxidation resistance of the friction stir welding tool. Further, in the friction stir welding tool of Comparative Example 2, the value of Bₛ/Bᵢ was 0.95, i.e., exceeded 0.9 to apparently result in low wear resistance and oxidation resistance and poor joining quality. Further, in the friction stir welding tool of Comparative Example 3, Al, which is not an iron group metal, was employed as a material constituting the binder phase, to apparently result in low wear resistance and oxidation resistance and poor joining quality.

Further, the friction stir welding tool of Example 2 apparently exhibited more excellent wear resistance and joining quality than those in Example 7. The performance of the friction stir welding tool of Example 2 was thus excellent presumably because the Ti compound was increased in base material surface portion of the friction stir welding tool of Example 2 whereas WC rather than the Ti compound was increased in the base material surface portion of the friction stir welding tool of

### Example 7.

Apparently, each of the friction stir welding tools of Examples 9 and 10 exhibited more excellent wear resistance and joining quality than those in Example 2. This is presumably because the surface of the friction stir welding tool of each of Examples 9 and 10 was coated with the coating layer whereas the surface of the friction stir welding tool of Example 2 was not coated with the coating layer.

Apparently, the friction stir welding tool of Example 9 exhibited more excellent wear resistance than that in Example 10. The wear resistance of the friction stir welding tool of Example 9 was thus excellent presumably because the coating layer of the friction stir welding tool of Example 9 had an oxidation starting temperature exceeding 1000°C. It is considered that the coating layer of the friction stir welding tool of Example 10 had an oxidation starting temperature lower than 1000°C to result in wear resistance inferior to that in Example 9.

Heretofore, the embodiments and examples of the present invention have been illustrated, but it has been initially expected to appropriately combine configurations of the embodiments and examples.

The embodiments and examples disclosed herein are illustrative and non-restrictive in any respect. The scope of the present invention is defined by the terms of the claims, rather than the embodiments described above, and is intended to include any modifications within the scope and meaning equivalent to the terms of the claims.

### REFERENCE SIGNS LIST

1: friction stir welding tool; 2: cylindrical portion; 3: probe portion; 4: base material; 5: coating layer.

## Claims

1. A friction stir welding tool (1) used for a friction stir welding process, comprising a base material (4),
said base material (4) including a hard phase and a binder phase,
said hard phase including TiCN and further including a compound or a solid solution of said compound, said compound being composed of one or more metals selected from a group consisting of Ti, Zr, Hf, V, Nb, Ta, Cr, Mo, and W and one or more elements selected from a group consisting of nitrogen, carbon, boron, and oxygen,
said binder phase being made of an iron group metal,
a mass ratio Bₛ of said binder phase to said base material (4) in a region having a thickness of 20 µm from a surface of said base material (4) being smaller than a mass ratio Bᵢ of said binder phase to said base material (4) in a region beyond the thickness of 20 µm from the surface of said base material (4).

2. The friction stir welding tool (1) according to claim 1, wherein a mass ratio Bₛ/Bᵢ, which is a mass ratio of said Bₛ to said Bᵢ, is 0 to 0.9.

3. The friction stir welding tool (1) according to claim 1, wherein a mass ratio of the Ti compound to said base material (4) in the region having the thickness of 20 µm from the surface of said base material (4) is higher than a mass ratio of the Ti compound to said base material (4) in the region beyond the thickness of 20 µm from the surface of said base material (4).

4. The friction stir welding tool (1) according to claim 1, wherein a portion of said base material (4) in contact with materials to be joined has a surface roughness Ra of 0.3 µm or smaller.

5. The friction stir welding tool (1) according to claim 1, wherein the friction stir welding tool (1) includes said base material (4) and a coating layer (5) formed on said base material (4).

6. The friction stir welding tool (1) according to claim 5, wherein said coating layer (5) has an oxidation resistance of 1000°C or greater.

7. The friction stir welding tool (1) according to claim 1, wherein said friction stir welding process using the friction stir welding tool (1) is spot friction stir welding.

8. A method for joining materials using the friction stir welding tool (1) recited in claim 1, said materials to be joined having a melting point of 1000°C or greater.
